# EUROPÄISCHE PATENTSCHRIFT

(11) **EP 1 034 555 B1**
(45) Veröffentlichungstag und Bekanntmachung des Hinweises auf die Patenterteilung: **30.01.2002**
(21) Anmeldenummer: 98956803.5
(22) Anmeldetag: 30.09.1998
(51) Int. Cl.: H01H 85/041, H01L 23/62

(54) **HALBLEITERBAUELEMENT MIT DEFINIERTEM VERHALTEN BEI EINEM AUSFALL UND VERFAHREN ZUR HERSTELLUNG EINES SOLCHEN**
SEMICONDUCTOR ELEMENT WITH DEFINED PERFORMANCE CHARACTERISTICS IN THE CASE OF FAILURE AND METHOD FOR THE PRODUCTION THEREOF
COMPOSANT A SEMI-CONDUCTEUR A COMPORTEMENT DEFINI EN CAS DE PANNE ET SON PROCEDE DE PRODUCTION

(30) Priorität: 25.11.1997 DE 19752196
(43) Veröffentlichungstag der Anmeldung: 13.09.2000
(73) Patentinhaber: Infineon Technologies AG, 81669 München (DE)
(72) Erfinder: MÄRZ, Martin, D-85570 Markt Schwaben (DE); SCHMID, Horst, D-81739 München (DE)
(74) Vertreter: Patentanwälte Westphal, Mussgnug & Partner
(86) Internationale Anmeldenummer: DE9802910
(87) Internationale Veröffentlichungsnummer: WO9927554

(56) Entgegenhaltungen:
- EP-A- 0 481 493
- EP-A- 0 554 195
- DE-A- 1 440 801
- US-A- 4 169 271
- US-A- 5 583 740
- US-A- 5 663 858

## Beschreibung

Die Erfindung bezieht sich auf ein Halbleiterbauelement und insbesondere einen Halbleiterschalter mit definiertem Verhalten bei einem Ausfall sowie auf ein Verfahren zur Herstellung eines solchen Halbleiterbauelements.

Halbleiterschalter finden heute eine immer raschere Verbreitung in der Kfz- und Industrie-Elektronik. Die sogenannten "smarten" Schalter zeichnen sich dabei durch umfangreiche, integrierte Schutzschaltungen gegen Überspannung, Überstrom und Übertemperatur aus, so daß in vielen Fällen auf eine zusätzliche Absicherung des Stromkreises verzichtet werden kann.

Bei den heute üblichen Halbleiter-Bauelementen in Gehäusen mit harter Vergußmasse (z.B. TO-220) führt eine extreme Überlastung im allgemeinen zu einem explosionsartigen Platzen des Gehäuses und damit zu einer Bonddraht-/Stromkreis-Unterbrechung. Es gibt in der Praxis aber einen sehr weiten Strombereich, in dem es nach einem Versagen des Schalters zwar zu einem Schmelzen des Bonddrahtes kommt, in dem durch die Preßmasse gebildeten Kanal aber für undefinierbar lange Zeiten eine leitfähige Verbindung aus flüssigem Aluminium bestehen bleibt. Im Extremfall ist der Energieumsatz bei durchlegiertem Chip so hoch, daß für mehrere Sekunden eine offene Flamme am Baustein entsteht - trotz der eigentlich nicht entflammbaren Preßmasse. Eine definierte Auslösecharakteristik im Sinne einer Schmelzsicherung ist damit nicht gegeben.

Gerade bei sicherheitsrelevanten Anwendungen im Kfz-Bereich stellt dies jedoch einen erheblichen Nachteil dar und beeinträchtigt den Einsatz solcher Bauelemente, da smarte Schalter zwar geschützt sind, aber in dem - wenn auch unwahrscheinlichen - Fall, daß der Schalter doch einmal versagt, die Situation nicht vorhersagbar ist und damit auch keine geeigneten Gegenmaßnahmen eingeplant werden können. Mit anderen Worten, es ist beim heutigen Stand der Technik ein definiertes Sicherungsverhalten (= Unterbrechung des Stromkreises) beim Versagen eines Bauelements der genannten Art nicht gewährleistet.

Ein gattungsgemäßes Halbleiterbauelement, das alle Merkmale des Oberbegriffs der Patentansprüche 1 bis 3 aufweist, ist in dem US-Patent US 5,663,858 beschrieben. Dort ist ein Halbleiterbauelement angegeben, bei dem die Bonddräht freiliegen indem sie sich von der Preßmasse des Halbleiterbauelementes abheben.

Ziel der vorliegenden Erfindung ist es daher, ein Halbleiterbauelement mit definierter Sicherungscharakteristik bei einem Ausfall zu schaffen sowie ein Herstellungsverfahren dafur anzugeben.

Dieses Ziel wird mittels eines Halbleiterbauelements mit den Merkmalen der unabhängigen Ansprüche 1 bis 3 und einem Herstellungsverfahren mit den Merkmalen des Anspruchs 9 erreicht. Die Unteransprüche beziehen sich auf bevorzugte Ausführungsformen der Erfindung.

Die erfindungsgemäße Lösung des Problems besteht darin, den oder die Bonddrähte zwischen einem Kontaktbereich auf dem Halbleitersubstrat und dem Außenanschluß oder die Anschlußpins des Bauelements als Schmelzsicherung zu verwenden, dabei aber durch gezielte konstruktive Gestaltung für eine definierte Auslösecharakteristik zu sorgen.

Erfindungsgemäß wird dazu die Drahtführung so gestaltet, daß der Bonddraht an einer Stelle an die Oberfläche der Preßmasse tritt, so daß ein Abschmelzen des Drahtes möglich ist und die Bildung eines leitfähigen Kanals aus flüssigem Metall innerhalb des Gehäuses vermieden wird.

Ein Halbleiterbauelement gemäß der vorliegenden Erfindung, das ein Halbleitersubstrat mit einem oder mehreren Kontaktgebieten und einen oder mehrere Außenanschlüsse umfaßt, wobei die Kontaktbereiche des Halbleitersubstrats mit einem jeweiligen Außenanschluß über wenigstens einen Bonddraht kontaktiert sind und das Halbleiterbauelement in einer Preßmasse eingegossen ist, ist dadurch gekennzeichnet, daß mindestens einer der Bonddrähte an einer Oberfläche der Preßmasse freiliegt und so dimensioniert ist, daß er bei einer vorgegebenen Stromstärke schmilzt, wobei die Oberfläche derart beschaffen ist, daß der geschmolzene Bonddraht abfließt.

In einer bevorzugten Ausführungsform weist bei dem erfindungsgemäßen Halbleiterbauelement die Oberfläche der Preßmasse eine Vertiefung oder eine Kerbe oder an einer Kante eine Sicke auf, in der mindestens einer der Bonddrähte freiliegt.

Vorzugsweise umfaßt mindestens einer der Bonddrähte einen ersten und einen zweiten Bonddraht-Abschnitt, die über eine Zwischeninsel miteinander verbunden sind, wobei der Bonddraht-Abschnitt freiliegt, der mit dem Außenanschluß verbunden ist.

Um ein Schmelzen bei großem Strom zu gewährleisten, wird der Drahtquerschnitt der Bonddrähte der gewünschten Sicherungscharakteristik angepaßt.

Wegen der geringen Drahtquerschnitte und dem niedrigen Schmelzpunkt (ca. 660°C) des in der Leistungselektronik allgemein verwendeten Bonddraht-Materials Aluminium eignen sich die Bonddrähte besonders vorteilhaft als Schmelzsicherung.

Das erfindungsgemäße Verfahren zum Herstellen eines Halbleiterbauelements, das ein Halbleitersubstrat mit einem oder mehreren Kontaktgebieten und einen oder mehrere Außenanschlüsse umfaßt, wobei die Kontaktbereiche des Halbleitersubstrats mit einem jeweiligen Außenanschluß über wenigstens einen Bonddraht kontaktiert sind, mit den Schritten: Befestigen des Halbleitersubstrats an einer Grundstruktur, Kontaktieren der Kontaktbereiche des Halbleitersubstrats mit einem jeweiligen Außenanschluß mit wenigstens einem Bonddraht und Vergießen des Halbleiterbauelements mit einer Preßmasse in einem Preßwerkzeug, so daß das Halbleitersubstrat hermetisch eingeschlossen ist, ist dadurch gekennzeichnet, daß der Bonddraht beim Verbinden des Außenanschlusses mit dem Halbleitersubstrat so geformt wird, daß der Bonddraht über die Oberfläche des Halbleiterbauelements übersteht und beim Vergießen gegen das Preßwerkzeug drückt.

Die Erfindung wird zum besseren Verständnis im folgenden unter Angabe von weiteren Merkmalen und Vorteilen anhand von zeichnerisch dargestellten Ausführungsbeispielen näher erläutert.

Fig. 1a und 1b zeigt den Aufbau einer Ausführungsform des erfindungsgemäßen Halbleiterbauelements im Querschnitt bzw. in Draufsicht.

Fig. 2 zeigt den Aufbau einer weiteren Ausführungsform des erfindungsgemäßen Halbleiterbauelements im Querschnitt.

Fig. 3a und 3b zeigt den Aufbau einer weiteren Ausführungsform des erfindungsgemäßen Halbleiterbauelements im Querschnitt bzw. in Draufsicht.

Fig. 4a und 4b zeigt den Aufbau einer weiteren Ausführungsform des erfindungsgemäßen Halbleiterbauelements im Querschnitt bzw. in Draufsicht.

Fig. 5 und 6 zeigen den Aufbau jeweils einer weiteren Ausführungsform des erfindungsgemäßen Halbleiterbauelements in Draufsicht.

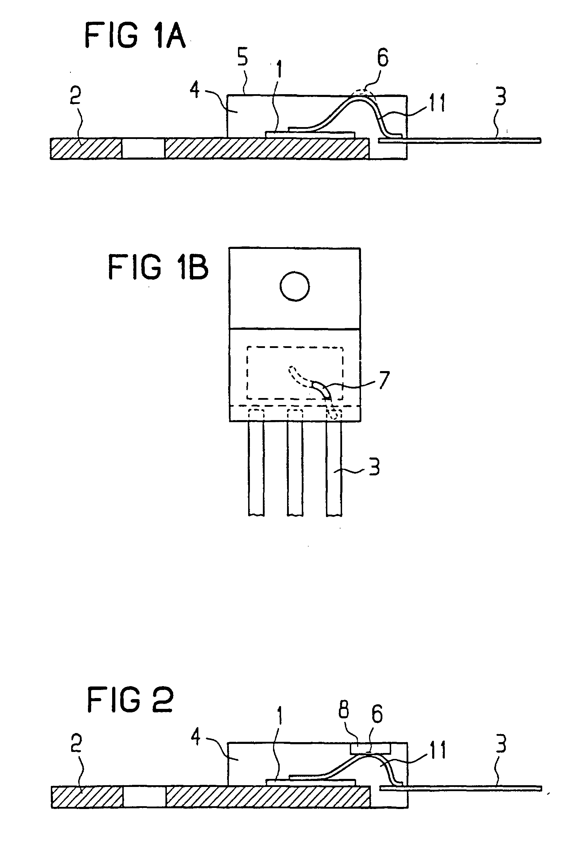

Fig. 1a zeigt eine erste erfindungsgemäße Ausführungsform des erfindungsgemäßen Halbleiterbauelements im Querschnitt. Das dargestellte Halbleiterbauelement umfaßt ein Halbleitersubstrat 1, das direkt elektrisch leitend oder über einen (nicht dargestellten) Isolator an einem Leadframe 2 befestigt ist. An das Halbleitersubstrat 1 wird über Außenanschlüsse 3 eine Spannung angelegt, bzw. es wird an dem Halbleitersubstrat 1 eine Spannung über die Außenanschlüsse 3 abgegriffen. Die Außenanschlüsse 3 werden mit (nicht dargestellten) Kontaktbereichen auf dem Halbleitersubstrat 1 über Bonddrähte 11 verbunden.

Zum Schutz des Halbleitersubstrats 1 und der Bonddrähte 11 wird der gesamte Aufbau des Bauelements mit seinen Außenanschlüssen 3 in einer Preßmasse 4 eingegossen. Die Preßmasse 4 ist dazu zunächst flüssig und härtet nach einer gegebenen Zeit aus, so daß sie die dann erreichte Form beibehält. Die Form der Preßmasse 4 wird durch ein Preßwerkzeug bestimmt. Das Preßwerkzeug gibt die Oberfläche 5 der Preßmasse 4 am Ende des Aushärteprozesses vor.

Erfindungsgemäß wird bei der Herstellung der Verbindung von den Kontaktbereichen auf dem Halbleitersubstrat 1 mit den Außenanschlüssen 3 über jeweils mindestens einen Bonddraht 11 der Bonddraht zu einem Bond-Loop 6 gebogen, der etwas über die spätere Oberfläche 5 der Preßmasse 4 hinausgezogen ist. Der Loop 6 ist in Fig. 1a gestrichelt so dargestellt, wie er vor dem Anpressen durch das Preßwerkzeug geformt ist. Beim Umpressen des Bausteins federt der Loop 6 gegen das (nicht dargestellte) Preßwerkzeug, so daß der Bonddraht 11 sicher an der Preßmassen-Oberfläche 5 des fertigen Bauteils zu liegen kommt. Beim Aushärten bleibt der Bonddraht 11 in Kontakt mit dem Preßwerkzeug und liegt bei dem fertigen Bauteil also sicher frei an dessen Oberfläche 5. Schmilzt nun der Bonddraht 11 bei Überlastung und Versagen des Bauelementes, so kann das Metall aus einer Öffnung 7 in der Preßmasse 4 austreten und die elektrische Verbindung zu den Kontaktbereichen auf dem Halbleitersubstrat 1 unterbrechen.

Die Oberfläche 5 des Halbleiterbauelements ist in Draufsicht in Fig. 1b dargestellt. Die Ausdehnung des Halbleiters 1 in der Preßmasse 3 ist gestrichelt gezeigt. Am oberen Ende der Preßmasse 3 schließt sich der Leadframe 2 an, der als Befestigung und Kühlkörper dient. Die unten in der Fig. 1b gezeigten Außenanschlüsse 3 enden in der Preßmasse 4 "blind" und sind über - teilweise gestrichelt dargestellte - Bonddrähte 11 in der Vergußmasse 4 mit Kontaktbereichen auf dem Halbleitersubstrat 1 verbunden. Die Bonddrähte treten in Öffnungen 7 aus der Preßmasse 4 an die Oberfläche 5 und liegen frei. So ist sichergestellt, daß bei einem Schmelzen des Bonddrahtes 11 aufgrund eines zu großen Stromes das flüssig gewordene Metall abfließen kann und somit die Verbindung von den Außenanschlüssen 3 zu den Kontaktbereichen des Halbleiters 1 sofort unterbrochen wird. Dadurch wird eine Beschädigung anderer Bauelemente zuverlässig vermieden.

In der in Fig. 1a und 1b gezeigten Ausführungsform der Erfindung ist die Oberfläche 5 des Bauelements eben, und die Loops 6 treten in der oberen Ebene in Fig. 1a und 1b an die Oberfläche. Stört jedoch bei bestimmten Anwendungen die "Kontaktstelle" an der Bauteil-Oberfläche 5 - beispielsweise bei einer Fixierung des Bauteils mit metallischen Feder-Clips - so kann die Austrittsstelle 7 des Bonddrahtes 11 auch in eine Vertiefung 8 in der Oberfläche 5 gelegt werden. Eine solche Ausführungsform ist in Fig. 2 dargestellt. Dabei kann als Vertiefung z.B. eine Auswerfer-Marke des Bauelements verwendet werden, was den Vorteil hat, daß kein zusätzlicher Fertigungsschritt erforderlich wird.

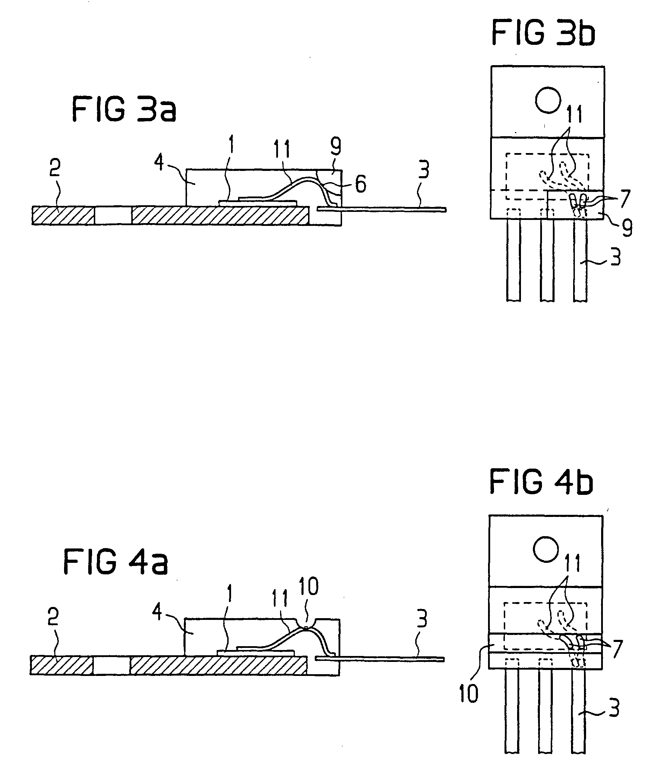

Eine weitere Ausführungsform des erfindungsgemäßen Halbleiterbauelements ist in Fig. 3a und 3b gezeigt. Da die Bauteile in der überwiegenden Anzahl der Fälle entweder in horizontaler oder in vertikaler Position eingebaut werden, kann es sein, daß im Falle des Schmelzens des Bonddrahtes 11 das flüssige Metall nicht abfließt, da die Stelle, an der der Draht 11 schmilzt, an einer tieferen Position als die Umgebung liegt. (Das Bauelement ist in Fig. 3a in "horizontaler" Lage gezeigt; "vertikal" bedeutet, daß das Bauelement um eine senkrecht zur Zeichenebene in Fig. 3a stehende Achse um + oder -90° gedreht wird.) Das hätte zur Folge, daß der Strompfad nicht wie gewünscht unterbrochen wird. Bei der in Fig. 3a und 3b gezeigten Ausführungsform wird dieser Fall durch eine geeignet geformte Sicke 9 in der Preßmasse 4 vermieden. Die Sicke 9 hat im wesentlichen die Form eines Viertelkreises und ist an einer Kante des Preßmasse 4 angeordnet. Dadurch wird sowohl bei horizontalem als auch bei vertikalem Einbau des Bauelements ein Ablaufen des flüssigen Metalls sichergestellt, denn in beiden Fällen befindet sich die Öffnung 7 in der Oberfläche, an der der Bonddraht 11 nach außen tritt, in der Mitte einer geneigten Fläche, so daß flüssiges Metall vom Bonddraht 11 ungehindert abfließen kann.

Wie aus der Draufsicht in Fig. 3b hervorgeht, kann die Sicke 9 auf einen Teil der Preßmasse beschränkt sein, d. h. die Sicke 9 muß sich nicht über eine ganze Kante erstrecken. Auch bei Erstreckung der Sicke nur über einen Teil der Kante der Preßmasse ist jedoch eine Unterbrechung des Strompfades bei nahezu beliebiger Einbaulage gewährleistet.

Eine weitere Ausführungsform der Erfindung ist in Fig. 4a und 4b gezeigt. Statt einer Vertiefung 8 in der Oberfläche 5 wie in Fig. 2 ist in der Ausführungsform nach Fig. 4a und 4b eine Kerbe-10 in der Oberfläche 5 vorgesehen, die im Querschnitt einen Halbkreis darstellt. Andere Formen des Querschnitts der Kerbe 10 wie die eines Dreiecks sind ebenfalls möglich. In Fig. 4b ist die Kerbe 10 in einem unteren Drittel des Gehäuses bzw. der Preßmasse 4 angeordnet dargestellt. Die letztendlich gewählte Lage der Kerbe 10 hängt dabei von den genauen Vorgaben des Gehäuses ab, d. h. davon, ob es ein Gehäuse vom Typ TO-220AB, TO-220AA, TO-220C, SOT-186 o. ä. ist.

Die Erfindung ist auch anwendbar bei Hochstrom-Transistoren, bei denen ein Anschlußpin 3 mit mehreren Bonddrähten 11 mit Kontaktbereichen auf dem Halbleitersubstrat 1 verbunden ist. Daher sind in Fig. 3b und 4b mehrere Bonddrähte 11 gezeigt, die von einem Außenanschluß 3 mit mehreren Kontaktbereichen auf dem Halbleiter verbunden sind.

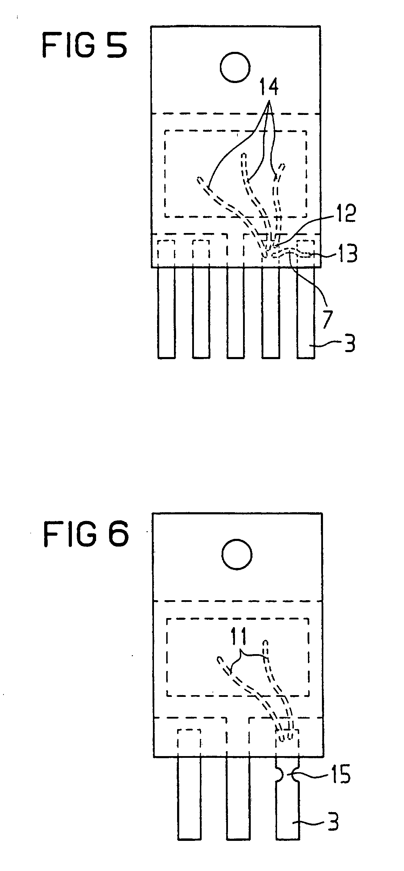

An der thermisch hoch belasteten Kontaktfläche zwischen Bonddraht 11 und Preßmasse 4 besteht die Gefahr des Eindringens von Feuchtigkeit in das Bauelement. Daher wird in der Ausführungsform nach Fig. 5 ein Zwischenschritt bei der Verbindung der Kontaktbereiche des Halbleiters mit den Außenanschlüssen vorgesehen. Dabei weise der oder die Bonddrähte 11 einen ersten Bonddraht-Abschnitt 13 und einen zweiten Bonddraht-Abschnitt 14 auf. Der erste Bonddraht-Abschnitt 13 wird vom Außenanschluß 3, der zweite Bonddraht-Abschnitt 14 wird vom Chip 1 auf eine Zwischeninsel 12 im Leadframe 2 gezogen. Diese Zwischeninsel 12 kann auch ein unbenutzter Anschlußpin 3 sein. Ein Vordringen von Feuchtigkeit zum Chip 1 wird damit sicher vermieden: die Feuchtigkeit könnte sich, wenn überhaupt, nur zwischen dem eigentlichen Außenanschluß 3 und der Zwischeninsel 12, d. h. am ersten Bonddraht-Abschnitt 13 ausbreiten.

Gerade bei Bausteinen mit mehreren, im allgemeinen auch unterschiedlich langen Bonddrähten 11 zwischen Halbleiter 1 und Außenanschluß 3 kann die Einstellung eines definierten Auslösestroms, d. h. eines Stromes, bei dem die Verbindung unterbrochen wird, problematisch sein. Die Ausführungsform mit der Zwischeninsel 12 nach Fig. 5 ermöglicht aber eine sehr flexible Lösung. Dazu werden die Bonddrähte 14 vom Chip 1 auf die Zwischeninsel 12 gezogen, von dort kann dann nur ein - entsprechend der gewünschten Auslösecharakteristik dimensionierter - Bonddraht 13 von der Zwischeninsel 12 zum Außenanschluß 3 gezogen werden.

Erreicht der Gesamtquerschnitt des oder der Bonddrähte 11 einen Querschnitt, der ein Schmelzen erst bei sehr großen Stromstärken zuläßt, ist es auch möglich, das erfindungsgemäße Sicherungsverhalten direkt durch eine gezielte Schwächung 15 des oder der Außenanschlüsse 3 gemäß Fig. 6 zu erreichen. Dazu wird der Außenanschluß 3 an einer vorgegebenen Stelle in einem vorgegebenen Maß wie in Fig. 6 gezeigt im Querschnitt reduziert. Das Maß der Reduzierung des Querschnitts des Außenanschlusses 3 an der Schwächung 15 hängt dabei von dem maximal zulässigen Strom sowie dem für den Außenanschluß 3 verwendeten Material ab.

## Patentansprüche

1. Halbleiterbauelement, das ein Halbleitersubstrat (1) mit einem oder mehreren Kontaktgebieten und einen oder mehrere Außenanschlüsse (3) umfaßt, wobei die Kontaktbereiche des Halbleitersubstrats (1) mit einem jeweiligen Außenanschluß (3) über wenigstens einen Bonddraht (11, 13, 14) kontaktiert sind und das Halbleiterbauelement in einer Preßmasse (4) eingegossen ist und wobei mindestens einer der Bonddrähte (11, 13, 14) an einer Oberfläche (5) der Preßmasse (4) freiliegt und so dimensioniert ist, daß er bei einer vorgegebenen Stromstärke schmilzt, wobei die Oberfläche (5) derart beschaffen ist, daß der geschmolzene Bonddraht (11, 13, 14) abfließt,
**dadurch gekennzeichnet, daß**
die Oberfläche (5) der Preßmasse (4) eine Vertiefung (8) aufweist, in der mindestens einer der Bonddrähte (11, 13, 14) freiliegt.

2. Halbleiterbauelement, das ein Halbleitersubstrat (1) mit einem oder mehreren Kontaktgebieten und einen oder mehrere Außenanschlüsse (3) umfaßt, wobei die Kontaktbereiche des Halbleitersubstrats (1) mit einem jeweiligen Außenanschluß (3) über wenigstens einen Bonddraht (11, 13, 14) kontaktiert sind und das Halbleiterbauelement in einer Preßmasse (4) eingegossen ist und wobei mindestens einer der Bonddrähte (11, 13, 14) an einer Oberfläche (5) der Preßmasse (4) freiliegt und so dimensioniert ist, daß er bei einer vorgegebenen Stromstärke schmilzt, wobei die Oberfläche (5) derart beschaffen ist, daß der geschmolzene Bonddraht (11, 13, 14) abfließt,
**dadurch gekennzeichnet, daß**
die Oberfläche (5) der Preßmasse (4) eine Kerbe (10) aufweist, in der mindestens einer der Bonddrähte (11, 13, 14) freiliegt.

3. Halbleiterbauelement, das ein Halbleitersubstrat (1) mit einem oder mehreren Kontaktgebieten und einen oder mehrere Außenanschlüsse (3) umfaßt, wobei die Kontaktbereiche des Halbleitersubstrats (1) mit einem jeweiligen Außenanschluß (3) über wenigstens einen Bonddraht (11, 13, 14) kontaktiert sind und das Halbleiterbauelement in einer Preßmasse (4) eingegossen ist und wobei mindestens einer der Bonddrähte (11, 13, 14) an einer Oberfläche (5) der Preßmasse (4) freiliegt und so dimensioniert ist, daß er bei einer vorgegebenen Stromstärke schmilzt, wobei die Oberfläche (5) derart beschaffen ist, daß der geschmolzene Bonddraht (11, 13, 14) abfließt,
**dadurch gekennzeichnet, daß**
die Oberfläche (5) der Preßmasse (4) eine Sicke (9) an einer Kante aufweist, in der mindestens einer der Bonddrähte (11, 13, 14) freiliegt.

4. Halbleiterbauelement nach einem oder mehreren der vorstehenden Ansprüche,
**dadurch gekennzeichnet, daß**
mindestens einer der Bonddrähte (11, 13, 14) einen ersten (13) und einen zweiten Bonddraht-Abschnitt (14) aufweist, die über eine Zwischeninsel (12) miteinander verbunden sind, wobei der Bonddraht-Abschnitt (13) freiliegt, der mit dem Außenanschluß (3) verbunden ist.

5. Halbleiterbauelement nach einem oder mehreren der vorstehenden Ansprüche,
**dadurch gekennzeichnet, daß**
der Drahtdurchmesser der Bonddrähte (11, 13, 14) kleiner als etwa 500 µm ist.

6. Halbleiterbauelement nach einem oder mehreren der vorstehenden Ansprüche,
**dadurch gekennzeichnet, daß**
die Bonddrähte (11, 13, 14) aus einem Material mit niedrigem Schmelzpunkt bestehen, wobei der Schmelzpunkt insbesondere bei ca. 660°C liegt.

7. Halbleiterbauelement nach Anspruch 6,
**dadurch gekennzeichnet, daß**
das Bonddraht-Material Aluminium ist.

8. Verfahren zum Herstellen eines Halbleiterbauelements gemäß einem der Ansprüche 1 bis 7, das ein Halbleitersubstrat (1) mit einem oder mehreren Kontaktgebieten und einen oder mehrere Außenanschlüsse (3) umfaßt, wobei die Kontaktbereiche des Halbleitersubstrats (1) mit einem jeweiligen Außenanschluß (3) über wenigstens einen Bonddraht (11, 13, 14) kontaktiert sind, mit den Verfahrensschritten:
(a) Befestigen des Halbleitersubstrats (1) an einer Grundstruktur (2);
(b) Kontaktieren der Kontaktbereiche des Halbleitersubstrats (1) mit einem jeweiligen Außenanschluß (3) mit wenigstens einem Bonddraht (11, 13, 14);
(c) Vergießen des Halbleiterbauelements in einem Preßwerkzeug mit einer Preßmasse (4), so daß das Halbleitersubstrat (1) hermetisch eingeschlossen ist;
(d) Der Bonddraht (11, 13, 14) wird beim Verbinden des Außenanschlusses (3) mit dem Halbleitersubstrat (1) so geformt, daß der Bonddraht (11, 13, 14) über die Oberfläche (5) des Halbleiterbauelements übersteht und beim Vergießen gegen das Preßwerkzeug drückt.

## Claims

1. A semiconductor component comprising a semiconductor substrate (1) with one or more contact areas and one or more external connections (3), the contact areas of the semiconductor substrate (1) being bonded with a respective external connection (3) via at least one bonding wire (11, 13, 14) and the semiconductor component being encapsulated in a moulding compound (4) and at least one of the bonding wires (11, 13, 15) being exposed at a surface (5) of the moulding compound (4) and being dimensioned so that it melts at a predetermined current intensity, the surface (5) being in such condition that the bonding wire (11, 13, 14) flows away,
**characterised in that** the surface (5) of the moulding compound (4) comprises a depression (8) in which at least one of the bonding wires (11, 13, 14) is exposed.

2. A semiconductor component comprising a semiconductor substrate (1) with one or more contact areas and one or more external connections (3), the contact areas of the semiconductor substrate (1) being bonded with a respective external connection (3) via at least one bonding wire (11, 13, 14) and the semiconductor component being encapsulated in a moulding compound (4) and at least one of the bonding wires (11, 13, 14) being exposed at a surface (5) of the moulding compound (4) and being dimensioned so that it melts at a predetermined current intensity, the surface (5) being in such condition that the melted bonding wire (11, 13, 14) flows away,
**characterised in that** the surface (5) of the moulding compound (4) comprises a notch (10) in which at least one of the bonding wires (11, 13, 14) is exposed.

3. A semiconductor component comprising a semiconductor substrate (1) with one or more contact areas and one or more external connections (3), the contact regions of the semiconductor substrate (1) being bonded with a respective external connection (3) via at least one bonding wire (11, 13, 14) and the semiconductor component being encapsulated in a moulding compound (4) and at least one of the bonding wires (11, 13, 14) being exposed at a surface (5) of the moulding compound (4) and being dimensioned so that it melts at a predetermined current intensity, the surface (5) being in such condition that the melted bonding wire (11, 13, 14) flows away,
**characterised in that** the surface (5) of the moulding compound (4) comprises a bead (9) at an edge in which at least one of the bonding wires (11, 13, 14) is exposed.

4. A semiconductor component according to one or more of the preceding Claims,
**characterised in that** at least one of the bonding wires (11, 13, 14) comprises a first (13) and a second bonding wire portion (14), which are connected to one another via an intermediate island (12), the bonding wire portion (13) which is connected to the external connections (3) being exposed.

5. A semiconductor component according to one or more of the preceding Claims,
**characterised in that** the wire diameter of the bonding wires (11, 13, 14) is less than roughly 500 µm.

6. A semiconductor component according to one or more of the preceding Claims,
**characterised in that** the bonding wires (11, 13, 14) are made from a material with a low melting point, the melting point lying in particular at roughly 660°C.

7. A semiconductor component according to Claim 6,
**characterised in that** the material of the bonding wire is aluminium.

8. A method for the manufacture of a semiconductor component according to one of Claims 1 to 7, comprising a semiconductor substrate (1) with one or more contact areas and one or more external connections (3), the contact areas of the semiconductor substrate (1) being bonded with a respective external connection (3) via at least one bonding wire (11, 13, 14), with the process steps :
(a) attachment of the semiconductor substrate (1) to a base structure (2);
(b) bonding the contact areas of the semiconductor substrate (1) with a respective external connection (3) by at least one bonding wire (11, 13, 14);
(c) encapsulating the semiconductor component in a compression moulding die with a moulding compound (4), so that the semiconductor substrate (1) is hermetically enclosed;
(d) when the external connection (3) is connected to the semiconductor substrate (1), the bonding wire (11, 13, 14) is shaped so that the bonding wire (11, 13, 14) projects above the surface (5) of the semiconductor component and presses against the compression moulding die during encapsulation.

## Revendications

1. Composant semi-conducteur comprenant un substrat semi-conducteur (1) avec une ou plusieurs zones de contact et un ou plusieurs branchement extérieurs (3), les zones de contact du substrat semi-conducteur (1) étant en contact avec un branchement extérieur respectif (3) par au moins un fil de liaison (11, 13, 14) et le composant semi-conducteur est noyé dans une masse pressée (4), et au moins l'un des fils de liaison (11, 13, 14) est dégagé à la surface supérieure (5) de la masse pressée (4) et il est dimensionné pour fondre pour une intensité de courant prédéterminée, la surface (5) étant telle que le fil de liaison fondu (11, 13, 14) coule.
**caractérisé en ce que**
la surface (5) de la masse pressée (4) comporte une cavité (8) dans laquelle au moins l'un des fils de liaison (11, 13, 14) est dégagé.

2. Composant semi-conducteur formé d'un substrat semi-conducteur (1) avec une ou plusieurs zones de contact et un ou plusieurs branchements d'extérieurs (3),
les zones de contact du substrat semi-conducteur (1) étant en contact avec un branchement extérieur respectif (3) par au moins un fil de liaison (11, 13, 14) et le composant semi-conducteur est noyé dans une masse pressée (4) et au moins l'un des fils de liaison (11, 13, 14) est libéré à la surface supérieure (5) de la masse pressée (4) et il est dimensionné pour fondre pour une intensité de courant prédéterminée, la surface supérieure (5) étant réalisée pour que le fil de liaison (11, 13, 14) coule,
**caractérisé en ce que**
la surface (5) de la masse pressée (4) comporte une encoche (10) dans la quelle au moins l'un des fils de liaison (11, 13, 14) est dégagé.

3. Composant semi-conducteur comprenant un substrat semi-conducteur (1) avec une ou plusieurs zones de contact et un ou plusieurs branchements (3),
les zones de contact du substrat semi-conducteur (1) étant en contact avec un branchement extérieur respectif (3) par au moins un fil de liaison (11, 13, 14) et le composant semi-conducteur est noyé dans une masse pressée (4) et au moins l'un des fils de liaison (11, 13, 14) est dégagé à la surface supérieure (5) de la masse pressée (4) et ce fil est dimensionné pour fondre à une intensité de courant prédéfinie, la surface (5) étant développée pour que le fil de liaison fondu (11, 13, 14) s'écoule,
**caractérisé en ce que**
la surface (5) de la masse pressée (4) comporte une rainure (9) à une arête avec au moins un des fils de liaison (11, 13, 14) qui est dégagé.

4. Composant semi-conducteur selon l'une quelconque des revendications précédentes,
**caractérisé en ce qu'**
au moins l'un des fils de liaison (11, 13, 14) comprend un premier segment (13) et un second segment (14) reliés par un ilot intermédiaire (12), le segment de fil de liaison (13) relié au branchement extérieur (3) étant dégagé.

5. Composant semi-conducteur selon l'une ou plusieurs des revendications précédentes,
**caractérisé en ce que**
le diamètre des fils de liaison est inférieur à environ 500 µm.

6. Composant semi-conducteur selon l'une ou plusieurs des revendications précédentes,
**caractérisé en ce que**
les fils de liaison sont réalisés dans un matériau à faible point de fusion et ce point de fusion est notamment situé à environ 660°C.

7. Composant semi-conducteur selon la revendication 6,
**caractérisé en ce que**
la matière du fil de liaison est de l'aluminium.

8. Procédé de fabrication d'un composant semi-conducteur selon l'une quelconque des revendications 1 à 7,
dans lequel un substrat semi-conducteur (1) comprend une ou plusieurs zones de contact et un ou plusieurs branchements extérieurs (3), les zones de contact du substrat semi-conducteur (1) étant mises en contact avec un branchement extérieur respectif (3) par au moins un fil de liaison (11, 13, 14), procédé comprenant les étapes suivantes :
a) on fixe le substrat semi-conducteur (1) à une structure de base (2),
b) on relie la zone de contact du substrat semi-conducteur (1) avec le branchement extérieur respectif (3) ayant au moins un fil de liaison (13, 14),
c) on coule le composant semi-conducteur dans un outil de presse avec une masse pressée (4) pour emprisonner hermétiquement le substrat semi-conducteur (1),
d) on met en forme le fil de liaison (11, 13, 14) lors de la liaison du branchement extérieur (13) avec le substrat semi-conducteur (1) pour que le fil de liaison (11, 13, 14) dépasse de la surface supérieure (5) du composant semi-conducteur et s'appuie contre l'outil de presse lors de la coulée.
